(19) Europäisches Patentamt
European Patent Office
Office européen des brevets

(11) **EP 3 171 520 A1**

(12) **EUROPEAN PATENT APPLICATION**
published in accordance with Art. 153(4) EPC

(43) Date of publication:
**24.05.2017 Bulletin 2017/21**

(21) Application number: **14899052.6**

(22) Date of filing: **31.07.2014**

(51) Int Cl.:
**H03M 13/05** (2006.01)

(86) International application number:
**PCT/CN2014/083434**

(87) International publication number:
**WO 2016/015288 (04.02.2016 Gazette 2016/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Huawei Technologies Co. Ltd.
Shenzhen, Guangdong 518129 (CN)**

(72) Inventors:
- **LI, Mo
  Shenzhen
  Guangdong 518129 (CN)**
- **YU, Fan
  Shenzhen
  Guangdong 518129 (CN)**
- **XIAO, Zhiyu
  Shenzhen
  Guangdong 518129 (CN)**

(74) Representative: **Maiwald Patentanwalts GmbH
Engineering
Elisenhof
Elisenstrasse 3
80335 München (DE)**

(54) **DECODING METHOD AND DECODER**

(57)     Embodiments of the present invention provide a decoding method and a decoder. The decoding method includes: after performing soft-decision decoding at least once on multiple codewords, determining whether a decoding result of soft-decision decoding meets a switching condition for switching to hard-decision decoding; and if the switching condition is not met, continuing to use soft-decision decoding during next decoding; or if the switching condition is met, switching to hard-decision decoding during next decoding, and always using hard-decision decoding during subsequent decoding until a decoding iteration is quit. In this way, when a decoding result of soft-decision decoding meets a specific condition, decoding can switch to hard-decision decoding that requires lower power consumption, and continual use of soft-decision decoding that requires higher power consumption can be avoided, thereby reducing power consumption of a decoder without impairing decoding performance.

FIG. 1

EP 3 171 520 A1

**Description**

**TECHNICAL FIELD**

Embodiments of the present invention relate to the communications field, and in particular, to a decoding method and a decoder.

**BACKGROUND**

In a high-speed optical transmission system, a forward error correction (Forward error correction, FEC) technology is required to improve transmission performance of the system, so as to support a longer transmission distance. FEC means that to-be-transmitted data is encoded at a transmit end according to a specific rule, causing some redundancy (that is, an overhead), and decoding is performed at a receive end according to a corresponding coding rule, to correct a data transmission error resulting from noise or channel impairment during transmission. FEC may be classified into hard-decision FEC and soft-decision FEC according to a decoding manner.

Hard-decision FEC means that a value of each bit of data input into an FEC decoder can only be 0 or 1, and the input data is referred to as hard information. A decoder calculates and updates only hard information during decoding, and finally outputs hard information. Soft-decision FEC means that each bit of data input into an FEC decoder is represented as a floating-point numerical value or a fixed-point numerical value that is quantized to multiple values. A symbol of the numerical value indicates a value (0 or 1) of the bit. An absolute value of the numerical value indicates a confidence level of the value. The input data is referred to as soft information. A decoder calculates and updates soft information during decoding, and finally outputs hard information.

Hard-decision FEC has low implementation complexity and requires low power consumption, but brings a smaller enhancement in performance of a transmission system than soft-decision FEC does. Soft-decision FEC brings a greater enhancement in the performance of the transmission system than hard-decision FEC does, but has high implementation complexity and power consumption. Therefore, different decoding manners need to be selected according to different application scenarios. For this reason, in current FEC chip design, it is expected that decoding in multiple application scenarios can be supported in one FEC chip, and that requirements on power consumption, a delay, and the like of a system can be met.

Therefore, an existing decoder includes a hard-decision module and a soft-decision module. When decoding starts, the hard-decision module is first enabled, to perform hard-decision decoding on input data and detect a hard-decision decoding result after each time of hard decision decoding. When an error (referred to as a residual bit error) in the hard-decision decoding result meets a specific condition, the soft-decision module is enabled to perform soft-decision decoding. In the foregoing conventional technology, soft-decision decoding is used only when data cannot be correctly decoded by means of hard-decision decoding, and data that is unsuccessfully decoded by means of hard-decision decoding needs to be re-decoded by using soft-decision decoding. To avoid this problem, in another conventional technology, soft-decision decoding is directly used, and decoding is quit when a decoding result meets a specific condition. However, generally, there are few residual bit errors in several times of soft-decision decoding before decoding is quit. As a result, using soft-decision decoding causes most resources of a decoder to be wasted and much power to be unnecessarily consumed.

**SUMMARY**

Embodiments of the present invention provide a decoding method and a decoder, so as to reduce power consumption of the decoder without impairing decoding performance.

According to a first aspect, an embodiment of the present invention provides a decoding method, where the method includes the following steps:

(a) performing N times of soft-decision decoding on multiple codewords, where N is greater than or equal to 1, and performing step (b) after completing the N times of soft-decision decoding;
(b) determining whether a decoding result in step (a) meets a switching condition for switching to hard-decision decoding; and performing step (c) if the switching condition is met; or returning to step (a) if the switching condition is not met; and
(c) performing hard-decision decoding on the decoding result in step (a) until a decoding iteration is quit.

With reference to the first aspect, in a first possible implementation manner, the determining whether a decoding result in step (a) meets a switching condition for switching to hard-decision decoding includes:

determining whether a quantity of accurately decoded codewords in the decoding result in step (a) reaches a preset target quantity; and determining that the switching condition is met if the preset target quantity is reached; or determining that the switching condition is not met if the preset target quantity is not reached; or
obtaining decoding accuracy according to the quantity of accurately decoded codewords, where the decoding accuracy is a ratio of a quantity of accurately decoded codewords to a total quantity of decoded codewords in one soft-decision decoding process;
determining whether the decoding accuracy is less than preset target accuracy; and
determining that the switching condition is not met if the decoding accuracy is less than the preset target accuracy; or
determining that the switching condition is met if the decoding accuracy is greater than or equal to the preset target accuracy.

With reference to the first possible implementation manner of the first aspect, in a second possible implementation manner, the preset target quantity and the preset target accuracy are preset according to an error correction capability of hard-decision decoding, where
the preset target quantity is equal to a total quantity of codewords in one soft-decision decoding process minus a quantity of erroneous codewords that can be corrected by means of hard-decision decoding; and
the preset target accuracy is equal to the preset target quantity divided by the total quantity of codewords in one soft-decision decoding process.

With reference to the first possible implementation manner of the first aspect, in a third possible implementation manner, the decoding result in step (a) includes a first decoding result of each codeword in the multiple codewords, and a method for obtaining the quantity of accurately decoded codewords in the decoding result in step (a) includes:

performing hard-decision decoding on the multiple codewords to obtain a second decoding result of each codeword in the multiple codewords; and
comparing the first decoding result of each codeword in the multiple codewords with the second decoding result of each codeword in turn, and determining that the codeword is accurately decoded if the first decoding result and the second decoding result of the codeword are the same, so as to obtain the quantity of accurately decoded codewords, where
a method for determining whether the first decoding result and the second decoding result are the same includes:

determining that the first decoding result and the second decoding result are the same if a value of each bit in the first decoding result of the codeword is exactly the same as a value of a corresponding bit in the second decoding result; or
determining that the first decoding result and the second decoding result are the same if a quantity of bits for which a value of each bit in the first decoding result of the codeword is different from a value of a corresponding bit in the second decoding result is less than or equal to a preset quantity.

With reference to any one of the first aspect, or the first to the third possible implementation manners of the first aspect, in a fourth possible implementation manner, step (c) includes:

(d) performing hard-decision decoding on the decoding result in step (a);
(e) obtaining a quantity of accurately decoded codewords in a decoding result in step (d); and
(f) determining whether the quantity of accurately decoded codewords is equal to a total quantity of codewords in the decoding result in step (d); and if the quantity of accurately decoded codewords is equal to the total quantity of codewords, determining that a quit condition is met and quitting a decoding iteration; or if the quantity of accurately decoded codewords is less than the total quantity of codewords, determining that a quit condition is not met, performing hard-decision decoding on the decoding result in step (d), and performing step (e) and step (f) again.

According to a second aspect, a decoder is provided, where the decoder includes:

a soft-decision decoding unit, configured to perform step (a): performing N times of soft-decision decoding on multiple codewords, where N is greater than or equal to 1, and performing step (b) after completing the N times of soft-decision decoding;
a switching control unit, configured to perform step (b): determining whether a decoding result in step (a) meets a switching condition for switching to hard-decision decoding; and performing step (c) if the switching condition is met; or returning to step (a) if the switching condition is not met; and
a hard-decision decoding unit, configured to perform step (c): performing hard-decision decoding on the decoding result in step (a) until a decoding iteration is quit.

With reference to the second aspect, in a first possible implementation manner, the switching control unit is specifically configured to:

determine whether a quantity of accurately decoded codewords in the decoding result in step (a) reaches a preset target quantity; and determine that the switching condition is met if the preset target quantity is reached; or determine that the switching condition is not met if the preset target quantity is not reached; or
obtain decoding accuracy according to the quantity of accurately decoded codewords, where the decoding accuracy is a ratio of a quantity of accurately decoded codewords to a total quantity of decoded codewords in one soft-decision decoding process;
determine whether the decoding accuracy is less than preset target accuracy; and
determine that the switching condition is not met if the decoding accuracy is less than the preset target accuracy; or
determine that the switching condition is met if the decoding accuracy is greater than or equal to the preset target accuracy.

With reference to the first possible implementation manner of the second aspect, in a second possible implementation manner, the preset target quantity and the preset target accuracy are preset according to an error correction capability of hard-decision decoding, where

the preset target quantity is equal to a total quantity of codewords in one soft-decision decoding process minus a quantity of erroneous codewords that can be corrected by means of hard-decision decoding; and

the preset target accuracy is equal to the preset target quantity divided by the total quantity of codewords in one soft-decision decoding process.

With reference to the first possible implementation manner of the second aspect, in a third possible implementation manner, the decoding result in step (a) includes a first decoding result of each codeword in the multiple codewords, and the hard-decision decoding unit is further configured to perform hard-decision decoding on the multiple codewords to obtain a second decoding result of each codeword in the multiple codewords; and the switching control unit is further specifically configured to:

compare the first decoding result of each codeword in the multiple codewords with the second decoding result of each codeword in turn, and determine that the codeword is accurately decoded if the first decoding result and the second decoding result of the codeword are the same, so as to obtain the quantity of accurately decoded codewords, where

a method for determining whether the first decoding result and the second decoding result are the same includes:

determining that the first decoding result and the second decoding result are the same if a value of each bit in the first decoding result of the codeword is exactly the same as a value of a corresponding bit in the second decoding result; or

determining that the first decoding result and the second decoding result are the same if a quantity of bits for which a value of each bit in the first decoding result of the codeword is different from a value of a corresponding bit in the second decoding result is less than or equal to a preset quantity.

With reference to any one of the second aspect, or the first to the third possible implementation manners of the second aspect, in a fourth possible implementation manner, the hard-decision decoding unit is further configured to:

(d) perform hard-decision decoding on the decoding result in step (a);
(e) obtain a quantity of accurately decoded codewords in a decoding result in step (d); and

(f) determine whether the quantity of accurately decoded codewords is equal to a total quantity of codewords in the decoding result in step (d); and if the quantity of accurately decoded codewords is equal to the total quantity of codewords, determine that a quit condition is met and quit a decoding iteration; or if the quantity of accurately decoded codewords is less than the total quantity of codewords, determine that a quit condition is not met, perform hard-decision decoding on the decoding result in step (d), and perform step (e) and step (f) again.

According to a third aspect, a decoder is provided, where the decoder includes a processor, a memory, and an input/output interface, where the processor, the memory, and the input/output interface are electrically connected by using a bus, the input/output interface is configured to interact with another device, the memory is configured to store a computer program, and the processor performs the following steps when the computer program is being executed by the processor:

(a) performing N times of soft-decision decoding on multiple codewords, where N is greater than or equal to 1, and performing step (b) after completing the N times of soft-decision decoding;
(b) determining whether a decoding result in step (a) meets a switching condition for switching to hard-decision decoding; and performing step (c) if the switching condition is met; or returning to step (a) if the switching condition is not met; and
(c) performing hard-decision decoding on the decoding result in step (a) until a decoding iteration is quit.

With reference to the third aspect, in a first possible implementation manner, the executing, by the processor, the computer program is specifically used to:

determine whether a quantity of accurately decoded codewords in the decoding result in step (a) reaches a preset target quantity; and determine that the switching condition is met if the preset target quantity is reached; or determine that the switching condition is not met if the preset target quantity is not reached; or

obtain decoding accuracy according to the quantity of accurately decoded codewords, where the decoding accuracy is a ratio of a quantity of accurately decoded codewords to a total quantity of decoded codewords in one soft-decision decoding process;

determine whether the decoding accuracy is less than preset target accuracy; and

determine that the switching condition is not met if the decoding accuracy is less than the preset target accuracy; or

determine that the switching condition is met if the decoding accuracy is greater than or equal to the preset target accuracy.

With reference to the first possible implementation manner of the third aspect, in a second possible implementation manner, the preset target quantity and the preset target accuracy are preset according to an error correction capability of hard-decision decoding, where the preset target quantity is equal to a total quantity of codewords in one soft-decision decoding process minus a quantity of erroneous codewords that can be corrected by means of hard-decision decoding; and the preset target accuracy is equal to the preset target quantity divided by the total quantity of codewords in one soft-decision decoding process.

With reference to the first possible implementation manner of the third aspect, in a third possible implementation manner, the decoding result in step (a) includes a first decoding result of each codeword in the multiple codewords, and the executing, by the processor, the computer program is specifically used to:

perform hard-decision decoding on the multiple codewords to obtain a second decoding result of each codeword in the multiple codewords; and compare the first decoding result of each codeword in the multiple codewords with the second decoding result of each codeword in turn, and determine that the codeword is accurately decoded if the first decoding result and the second decoding result of the codeword are the same, so as to obtain the quantity of accurately decoded codewords, where a method for determining whether the first decoding result and the second decoding result are the same includes:

determining that the first decoding result and the second decoding result are the same if a value of each bit in the first decoding result of the codeword is exactly the same as a value of a corresponding bit in the second decoding result; or determining that the first decoding result and the second decoding result are the same if a quantity of bits for which a value of each bit in the first decoding result of the codeword is different from a value of a corresponding bit in the second decoding result is less than or equal to a preset quantity.

With reference to any one of the third aspect or the first possible implementation manner of the third aspect, in a fourth possible implementation manner, the executing, by the processor, the computer program is specifically used to:

(d) perform hard-decision decoding on the decoding result in step (a);
(e) obtain a quantity of accurately decoded codewords in a decoding result in step (d); and
(f) determine whether the quantity of accurately decoded codewords is equal to a total quantity of codewords in the decoding result in step (d); and if the quantity of accurately decoded codewords is equal to the total quantity of codewords, determine that a quit condition is met and quit a decoding iteration; or if the quantity of accurately decoded codewords is less than the total quantity of codewords, determine that a quit condition is not met, perform hard-decision decoding on the decoding result in step (d), and perform step (e) and step (f) again.

According to the decoding method and the decoder that are provided in the embodiments of the present invention, after soft-decision decoding is performed at least once on multiple codewords, whether a decoding result of soft-decision decoding meets a switching condition for switching to hard-decision decoding is determined; and if the switching condition is not met, soft-decision decoding continues to be used during next decoding; or if the switching condition is met, hard-decision decoding is switched to during next decoding, and hard-decision decoding is always used during subsequent decoding until a decoding iteration is quit. In this way, when a decoding result of soft-decision decoding meets a specific condition, decoding can switch to hard-decision decoding that requires lower power consumption, and continual use of soft-decision decoding that requires higher power consumption can be avoided, thereby reducing power consumption of a decoder without impairing decoding performance.

**BRIEF DESCRIPTION OF DRAWINGS**

To describe the technical solutions in the embodiments of the present invention or in the prior art more clearly, the following briefly describes the accompanying drawings required for describing the embodiments or the prior art. Apparently, the accompanying drawings in the following description show some embodiments of the present invention, and persons of ordinary skill in the art may still derive other drawings from these accompanying drawings without creative efforts.

FIG. 1 is a schematic flowchart of a decoding method according to an embodiment of the present invention;
FIG. 2 is another schematic flowchart of a decoding method according to an embodiment of the present invention;
FIG. 3 is a schematic diagram of a coding scheme according to an embodiment of the present invention;
FIG. 4 is a schematic diagram of a method for obtaining a basic sequence according to an embodiment of the present invention;
FIG. 5 is a schematic diagram of a method for obtaining a test sequence according to an embodiment of the present invention;
FIG. 6 is a schematic diagram of a decoding scheme according to an embodiment of the present invention;

FIG. 7 is a schematic structural diagram of a decoder according to an embodiment of the present invention; and

FIG. 8 is another schematic structural diagram of a decoder according to an embodiment of the present invention.

## DESCRIPTION OF EMBODIMENTS

To make the objectives, technical solutions, and advantages of the embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by persons of ordinary skill in the art based on the embodiments of the present invention without creative efforts shall fall within the protection scope of the present invention.

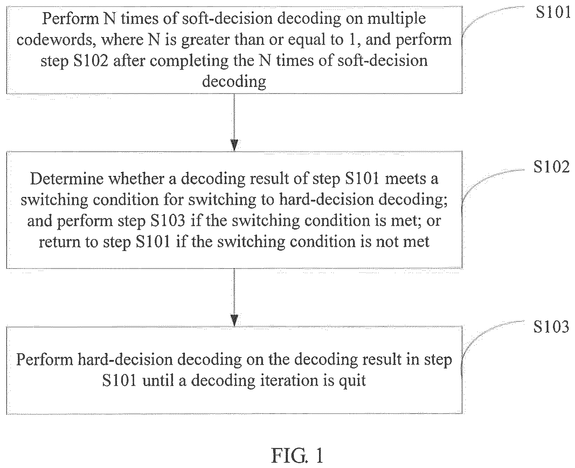

An embodiment of the present invention provides a decoding method. As shown in FIG. 1, the method includes:

S101: Perform N times of soft-decision decoding on multiple codewords, where N is greater than or equal to 1, and perform step S102 after completing the N times of soft-decision decoding.

S102: Determine whether a decoding result in step S101 meets a switching condition for switching to hard-decision decoding; and perform step S103 if the switching condition is met; or return to step S101 if the switching condition is not met.

S103: Perform hard-decision decoding on the decoding result in step S101 until a decoding iteration is quit.

It should be noted that, generally, N may be set to 1. That is, whether decoding switches to hard-decision decoding is determined each time after soft-decision decoding is performed. When the switching condition is not met, switching is not performed, and soft-decision decoding continues to be used to decode the multiple codewords during next decoding. When N = 1, generally, a codeword in next soft-decision decoding is different from a codeword in current soft-decision decoding, but a quantity of codewords in next soft-decision decoding and a quantity of codewords in current soft-decision decoding are the same. When the switching condition is met, decoding switches to hard-decision decoding, and hard-decision decoding is performed on the decoding result in step S101. This can be understood as that, hard-decision decoding is used during next decoding when a decoding result of current soft-decision decoding meets a switching condition, and multiple codewords in the next decoding generally include all or some of codewords in a decoding result of the current soft-decision decoding. Whether all or some of the codewords in the decoding result of the current soft-decision decoding are included depends on a coding scheme that is used for data.

According to the decoding method provided in this embodiment of the present invention, after soft-decision decoding is performed at least once on multiple codewords, whether a decoding result of soft-decision decoding meets a switching condition for switching to hard-decision decoding is determined; and if the switching condition is not met, soft-decision decoding continues to be used during next decoding; or if the switching condition is met, hard-decision decoding is switched to during next decoding, and hard-decision decoding is always used during subsequent decoding until a decoding iteration is quit. In this way, when a decoding result of soft-decision decoding meets a specific condition, decoding can switch to hard-decision decoding that requires lower power consumption, and continual use of soft-decision decoding that requires higher power consumption can be avoided, thereby reducing power consumption of a decoder without impairing decoding performance.

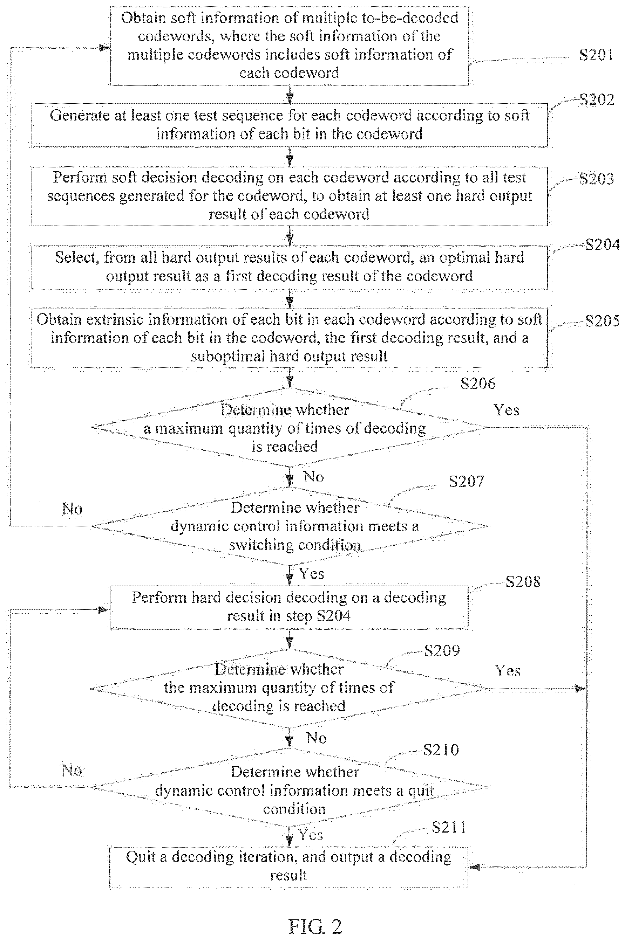

To make persons of skill in the art understand the technical solution provided in this embodiment of the present invention more clearly, the following provides, by describing a specific embodiment, a detailed description about the decoding method provided in this embodiment of the present invention. Moreover, to facilitate description, it is assumed that N = 1 in this embodiment, that is, whether decoding switches to hard-decision decoding needs to be determined each time after soft-decision decoding is performed. Exemplarily, a staircase (staircase) TPC (Turbo Product Code, Turbo product code) coding scheme may be used for a to-be-decoded codeword in this embodiment. As shown in FIG. 2, the method includes the following steps.

In the $N^{th}$ time of decoding (the $N^{th}$ time of decoding may be any soft-decision decoding in a soft-decision decoding process), a specific process of soft-decision decoding may include the following steps.

S201: Obtain soft information of multiple to-be-decoded codewords. The soft information of the multiple codewords includes soft information of each codeword.

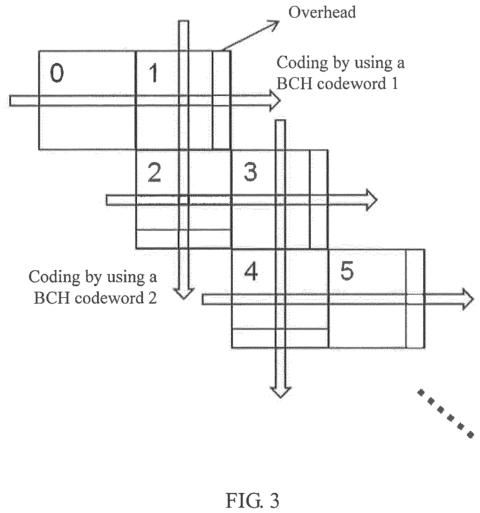

Specifically, the staircase TPC coding scheme used for a to-be-decoded codeword may be shown in FIG. 3. Each bit for which the coding scheme is used is coded and protected by using two BCH (Bose Ray-Chaudhuri Hocquenghe) sub-codewords: a transverse BCH sub-codeword 1 and a longitudinal BCH sub-codeword 2. Therefore, the coding scheme may be referred to as a soft-decision BCH algorithm. Exemplarily, a BCH codeword (512, 491) that can be used to correct three errors is used for both the transverse BCH sub-codeword 1 and the longitudinal BCH sub-codeword 2 (the BCH sub-codeword 1 and the BCH sub-codeword 2 can also be implemented by using different BCH codewords). A frame of data (256 x 256 bits) is used as a unit during coding, and two adjacent frames of data are coded by using one type of BCH codeword. As shown in FIG. 3, frame 0 and frame 1 are coded by using a transverse BCH codeword 1 (512, 491), and are transversely two hundred and fifty six 512-bit BCH codewords after being coded. Then, frame 1 and frame 2 are coded by using a longitudinal BCH codeword 2 (512, 491) (herein, one BCH coding scheme or different BCH coding schemes may be used for the BCH codeword 1 and the BCH codeword 2), and longitudinally are also two hundred and fifty six 512-bit BCH codewords after being coded.

Soft information of each codeword means soft information of a value of each bit in each codeword, includes the value and a confidence level of the value, and is mathematically represented as a logarithm of a ratio of a posterior probability that each bit is equal to 1 to a posterior probability that each bit is equal to 0. When a value of the soft information is positive, it indicates that the bit is more likely to be equal to 1; when a value of the soft information is negative, it indicates that the bit is more likely to be equal to 0. Magnitude of an absolute value of the soft information can indicate reliability of a corresponding value; a larger absolute value indicates a more reliable value.

Exemplarily, soft information of a bit in a codeword can be obtained by using the following algorithm:

$$APP_l = LLR + Ex\_inof_{l-1} \times \alpha \quad (1)$$

Herein, $APP_l$ represents soft information of the bit in the $l$th decoding iteration, *LLR* (Log Likelihood Ratio, log-likelihood ratio) represents an initial confidence level that is input over a channel, $Ex\_info_{l-1}$ is extrinsic information that is output in the $(l-1)$th decoding iteration ($l \le$ N, and *l* is a positive integer), $\alpha$ is a weight coefficient, and $\alpha$ slowly increases during an iteration.

According to the foregoing algorithm, it can be known that during the first time of decoding, LLR information, of each bit in each codeword, input over a channel is obtained as soft information; during the second time of decoding and subsequent soft-decision decoding, soft information of each bit in each code is obtained according to extrinsic information *Ex_info* corresponding to the bit and the LLR information, of the bit in the codeword, input over the channel.

S202: Generate at least one test sequence for each codeword according to soft information of each bit in the codeword.

A core idea of the foregoing soft-decision BCH algorithm is to try to estimate and correct a codeword error by using a limited quantity of test error patterns. Therefore, generating a test sequence is a key step in the algorithm, and a quantity of test sequences also affects performance of the algorithm greatly. According to what is mentioned above, an absolute value of soft information of a bit can indicate a confidence level of a value of the bit. A smaller absolute value indicates a less reliable value of the bit and a higher probability that the bit is an erroneous bit. Therefore, for a codeword, P bits with smallest absolute values of soft information in the codeword are first selected, and it is considered that errors of the codeword are most likely to appear at the P locations (P is an integer greater than zero, and a value of P can be set according to a need, which is not limited herein). Then, $2^P$ test sequences (Test Sequence, TS) are constructed according to the P locations. A specific construction method is as the following example.

After P bits of each codeword are selected, the P bits of each codeword are traversed by using two values (0 and 1) in turn, and a bit other than the P bits in the codeword is set to 0, so as to obtain $2^P$ basic sequences (Basic Sequence, BS).

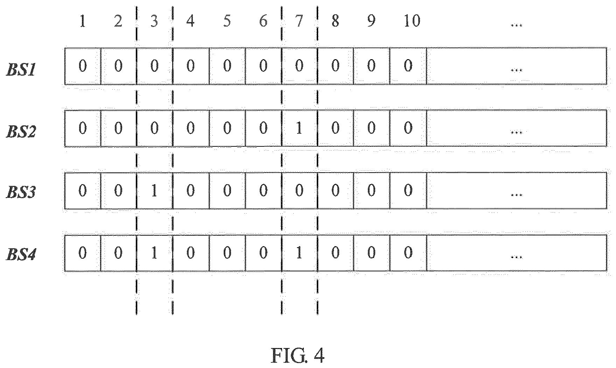

Exemplarily, it is assumed that P = 2, and that the two locations are the third bit and the seventh bit of the codeword; values of the third bit and the seventh bit are separately set to 1 and 0 in turn. In this way, $2^2 = 4$ BSs (BS 1 to BS 4) are obtained, as shown in FIG. 4.

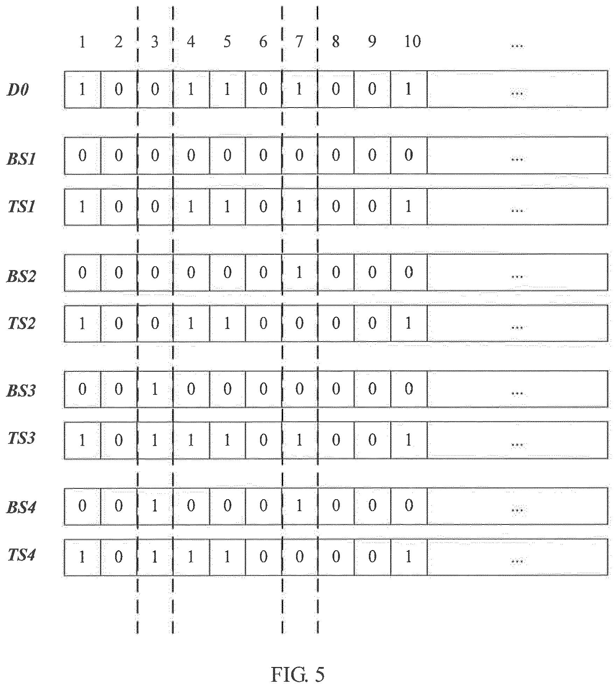

After the BSs are obtained, a second decoding result, of each codeword, obtained by performing hard-decision decoding on soft information of the codeword is obtained, and is denoted by $D_0$; $2^P$ TSs of each codeword are obtained by using $D_0$ of the codeword and $2^P$ BSs of the codeword. Specifically, modular two addition is performed on $D_0$ of each codeword and $2^P$ basic sequences of the codeword to obtain $2^P$ TSs. Exemplarily, the four BSs (BS 1 to BS 4) shown in FIG. 4 are used for constructing TSs, and obtained TSs (TS 1 to TS 4) may be shown in FIG. 5.

S203: Perform soft-decision decoding on each codeword according to all test sequences generated for the codeword, to obtain at least one hard output result of each codeword.

After soft-decision decoding is performed, K output codewords, that is, K hard output results, are obtained, where $K \le 2^P$. This is because some TSs may be beyond a decoding capability and consequently cannot be decoded normally.

S204: Select, from all hard output results of each codeword, an optimal hard output result as a first decoding result of the codeword.

Exemplarily, selection of an optimal hard output result from K hard output results obtained after soft-decision decoding is performed on a codeword may be implemented by performing the following steps.

First, a Euclidean distance between the K hard output results of the codeword and soft information of the codeword is obtained. The Euclidean distance can be obtained by using a Euclidean distance formula according to a value of each bit in each hard output result of the codeword and soft information of each bit of the codeword, for example:

$$d_i = \sqrt{\sum_{k=1}^{N}\left(x_{1k} - x_{2k}\right)^2} \quad (2)$$

Herein, $d_i$ represents a Euclidean distance between a hard output result i in K hard output results of a codeword and soft information of the codeword, the hard output result i is any one of the K hard output results of the codeword, $x_{1k}$ represents a value of the $k^{th}$ bit in the hard output result i, and $x_{2k}$ represents a value of soft information of the $k^{th}$ bit in the codeword.

It should be noted that, during calculation of a Euclidean distance, a value of a bit in a hard output result needs to be correspondingly converted from (1, 0) to (1, -1), so as to correspond to a value range of soft information.

According to the foregoing algorithm, K Euclidean distances can be obtained according to the K hard output results, and then a hard output result corresponding to a smallest Euclidean distance is selected as the optimal hard output result, which is used as a first decoding result.

S205: Obtain extrinsic information of each bit in each codeword according to soft information of each bit in the codeword, the first decoding result, and a suboptimal hard output result.

Performance of used FEC is improved in a manner of combining convolutional coding with window decoding. Therefore, after current soft-decision decoding is completed, extrinsic information *Ex_info,* of each bit, obtained through the current decoding needs to be calculated and transferred to next soft-decision decoding, so as to generate soft information for the next soft-decision decoding, thereby implementing effective transfer of a confidence level during decoding.

Exemplarily, extrinsic information can be obtained according to the following algorithm:

$$w_j = \left(\frac{|R-C|^2 - |R-D|^2}{4}\right)d_j - r_j \quad (3)$$

Herein, $w_j$ represents extrinsic information of the $j^{th}$ bit in a codeword, $R$ represents input soft information for soft-decision decoding, $D$ is a first decoding result (that is, the optimal hard output result described above) of the codeword, $C$ is a suboptimal hard output result (an optimal hard output result, except the optimal hard output result, in all hard output results of the codeword; also referred to as a competition codeword), and $d_j$ is a value (1/-1) of the $j^{th}$ bit in $D$. Because a value of P is limited, it is possible that $C$ that meets the foregoing requirement cannot be found in K output results. In this case, the extrinsic information of the bit can be obtained by using the following approximation algorithm:

$$w_j = \beta d_j \quad (4)$$

Herein, $\beta$ is a weight coefficient whose value slowly increases in a decoding process. A specific value of $\beta$ can be obtained by means of simulation optimization.

It can be seen that a decoding result of each soft-decision decoding affects next soft-decision decoding by means of extrinsic information. Therefore, all of the foregoing soft-decision decoding can also be referred to as one decoding iteration.

S206: Determine whether a maximum quantity of times of decoding is reached; and perform step S211 if the maximum quantity of times of decoding is reached, or otherwise, perform step S207.

S207: Obtain dynamic control information related to soft-decision decoding according to a decoding result, and determine whether the dynamic control information meets a switching condition; and if the switching condition is met, perform step S208 in the $(N+1)^{th}$ time of decoding; or if the switching condition is not met, repeat step S201 to step S207 in the $(N+1)^{th}$ time of decoding.

Specifically, the dynamic control information may be a quantity of accurately decoded codewords or decoding accuracy in the $N^{th}$ time of decoding. The decoding accuracy means a ratio of a quantity of accurately decoded codewords to a total quantity of decoded codewords in one soft-decision decoding process.

First, if a quantity of accurately decoded codewords is used for determining whether a condition for switching to hard-decision decoding is met, the following may be included:

> determining whether a quantity of accurately decoded codewords in the decoding result obtained in step S204 reaches a preset target quantity; and determining that the switching condition is met if the preset target quantity is reached; or determining that the switching condition is not met if the preset target quantity is not reached.

The preset target quantity is set according to a quantity of erroneous codewords that can be corrected by means of hard-decision decoding. Generally, the preset target quantity is equal to a total quantity of codewords in one soft-decision decoding process minus a quantity of erroneous codewords that can be corrected by means of hard-decision decoding. For example, if the quantity of erroneous codewords that can be corrected by means of hard-decision decoding is 3, because a quantity of codewords in one soft-decision decoding process in this embodiment is 256, the preset target quantity may be set to 253, or may be set to any one of 254 to 256. In addition, the quantity of erroneous codewords that can be corrected by means of hard-decision decoding is generally determined by performance of a decoding kernel in a decoder.

Whether a codeword in the decoding result is accurately decoded can be determined in the following manner:

using a decoding result, of each codeword, obtained in step S204 as a first decoding result of the codeword, and performing hard-decision decoding on the multiple codewords in step S201 to obtain a second decoding result of each codeword in the multiple codewords; and

comparing the first decoding result of each codeword with the second decoding result of the codeword in turn; and if the first decoding result and the second decoding result of the codeword are the same, determining that the codeword is accurately decoded. Then statistics are collected to obtain a quantity of accurately decoded codewords.

Whether a first decoding result of a codeword and a second decoding result of the codeword are the same can be determined in the following manners:

comparing a value of each bit in the first decoding result of the codeword with a value of a corresponding bit in the second decoding result; and determining that the first decoding result and the second decoding result are the same if the value of each bit in the first decoding result of the codeword is exactly the same as the value of the corresponding bit in the second decoding result; or determining that the first decoding result and the second decoding result are the same if a quantity of bits for which a value of each bit in the first decoding result of the codeword is different from a value of a corresponding bit in the second decoding result is less than or equal to a preset quantity.

In order to facilitate understanding, exemplarily, in this embodiment, a codeword includes 512 bits, and a first decoding result obtained after soft-decision decoding is performed on the codeword and a second decoding result obtained after hard-decision decoding is performed on the codeword each also include 512 bits. The first bit in the first decoding result of the codeword is compared with the first bit in the second decoding result, the second bit in the first decoding result is compared with the second bit in the second decoding result, and so on. If the 512 bits in the first decoding result and the 512 bits in the second decoding result are the same, it can be determined that the first decoding result and the second decoding result are the same. Certainly, for some services, individual errors may be allowed. Therefore, a preset quantity, for example, 510, may be set as a threshold, and it can be determined that the first decoding result and the second decoding result are the same provided that a quantity of same bits between the 512 bits in the first decoding result and the 512 bits in the second decoding result is not less than 510.

Second, if decoding accuracy is used for determining whether a condition for switching to hard-decision decoding is met, the following may be included:

obtaining the decoding accuracy according to a quantity of accurately decoded codewords;
determining whether the decoding accuracy is less than preset target accuracy; and
determining that the switching condition is not met if the decoding accuracy is less than the preset target accuracy; or
determining that the switching condition is met if the decoding accuracy is greater than or equal to the preset target accuracy.

The preset target accuracy is equal to a preset target quantity divided by a total quantity of codewords in one soft-decision decoding process. A method for obtaining the preset target quantity is the same as the foregoing method, and is not further described.

Exemplarily, it is still assumed that a quantity of erroneous codewords that can be corrected by means of hard-decision decoding is 3, and accordingly, the preset target accuracy = 253/256 ≈ 98.883%.

S208: Perform hard-decision decoding on a decoding result in step S204.

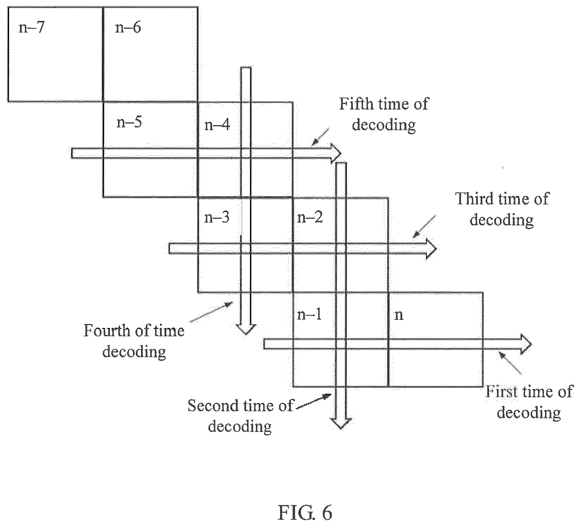

It should be noted that performing hard-decision decoding on the decoding result in step S204 should be understood as performing hard-decision decoding on all or some of codewords in the soft-decision decoding result in step S204. Whether hard-decision decoding is performed on all or some of the codewords in the decoding result depends on a coding scheme that is used for data. For example, in this embodiment, because the staircase TPC coding scheme shown in FIG. 3 is used, correspondingly, a decoding process may be shown in FIG. 6. During the first time of decoding, transverse decoding is performed on 256 codewords consisting of the $n^{th}$ frame of data and the $(n-1)^{th}$ frame of data (each frame of data includes 256 x 256 bits). After the first time of decoding is completed, a numerical value of each bit in the 256 codewords of the $n^{th}$ frame and the $(n-1)^{th}$ frame is updated. Then, longitudinal decoding is performed on the $(n-1)^{th}$ frame and the $(n-2)^{th}$ frame. It can be seen that a numerical value of each bit in the updated $(n-1)^{th}$ frame obtained after the first time of decoding is completed is used as a part of input codewords for the second time of decoding. That is, the second time of decoding is decoding performed on a part of a decoding result of the first time of decoding. The foregoing decoding manner is merely exemplary, and includes but is not limited to what is described herein.

S209: Determine whether the maximum quantity of times of decoding is reached; and perform step S211 if the maximum quantity of times of decoding is reached, or otherwise, perform step S210.

S210: Obtain dynamic control information related to hard-decision decoding according to a decoding result, and determine whether the dynamic control information meets a quit condition; and if the quit condition is met, perform step S211; or if the quit condition is not met, repeat step S208 to step S210 in the (N+2)th time of decoding.

The dynamic control information related to hard-decision decoding may be a quantity of accurately decoded codewords in a decoding result in step S208. The quantity of accurately decoded codewords is generally obtained from the decoding kernel of the decoder. For example, in hard-decision decoding, a quantity of accurately decoded codewords is obtained according to a quantity of errors reported by the decoding kernel for this time of decoding.

Whether the quit condition is met can be determined by determining whether the quantity of accurately decoded codewords is equal to a total quantity of codewords in the decoding result in step S204, that is, by determining whether no error occurs in hard-decision decoding. For example, if the decoding result in step S204 is 256 codewords, and a quantity of reported error is 0, it is determined that all the 256 codewords are accurately decoded and decoding can be quit.

S211: Quit a decoding iteration, and output a decoding result.

According to the decoding method provided in this embodiment of the present invention, after soft-decision decoding is performed at least once on multiple codewords, whether a decoding result of soft-decision decoding meets a switching condition for switching to hard-decision decoding is determined; and if the switching condition is not met, soft-decision decoding continues to be used during next decoding; or if the switching condition is met, hard-decision decoding is switched to during next decoding, and hard-decision decoding is always used during subsequent decoding until a decoding iteration is quit. In this way, when a decoding result of soft-decision decoding meets a specific condition, decoding can switch to hard-decision decoding that requires lower power consumption, and continual use of soft-decision decoding that requires higher power consumption can be avoided, thereby reducing power consumption of a decoder without impairing decoding performance.

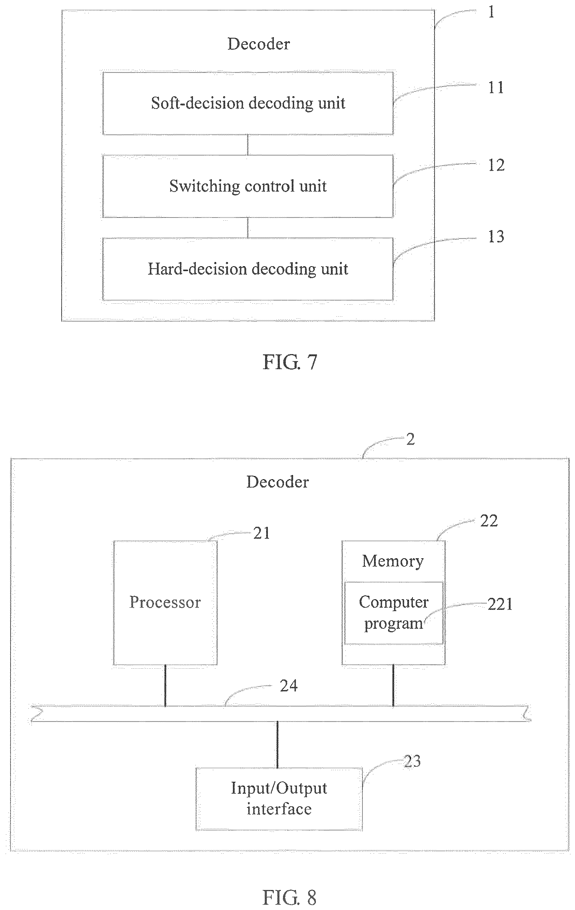

An embodiment of the present invention provides a decoder 1, and as shown in FIG. 7, the decoder 1 includes:

a soft-decision decoding unit 11, configured to perform step (a): performing N times of soft-decision decoding on multiple codewords, where N is greater than or equal to 1, and performing step (b) after completing the N times of soft-decision decoding;
a switching control unit 12, configured to perform step (b): determining whether a decoding result in step (a) meets a switching condition for switching to hard-decision decoding; and performing step (c) if the switching condition is met; or returning to step (a) if the switching condition is not met; and

a hard-decision decoding unit 13, configured to perform step (c): performing hard-decision decoding on the decoding result in step (a) until a decoding iteration is quit.

Optionally, the switching control unit 12 may be specifically configured to:

determine whether a quantity of accurately decoded codewords in the decoding result in step (a) reaches a preset target quantity; and determine that the switching condition is met if the preset target quantity is reached; or determine that the switching condition is not met if the preset target quantity is not reached; or
obtain decoding accuracy according to a quantity of accurately decoded codewords, where the decoding accuracy is a ratio of a quantity of accurately decoded codewords to a total quantity of decoded codewords in one soft-decision decoding process;
determine whether the decoding accuracy is less than preset target accuracy; and
determine that the switching condition is not met if the decoding accuracy is less than the preset target accuracy; or
determine that the switching condition is met if the decoding accuracy is greater than or equal to the preset target accuracy.

Optionally, the preset target quantity and the preset target accuracy are preset according to an error correction capability of hard-decision decoding, where the preset target quantity is equal to a total quantity of codewords in one soft-decision decoding process minus a quantity of erroneous codewords that can be corrected by means of hard-decision decoding; and the preset target accuracy is equal to the preset target quantity divided by the total quantity of codewords in one soft-decision decoding process.

Optionally, the decoding result in step (a) includes a first decoding result of each codeword in the multiple codewords. The hard-decision decoding unit 13 may be further configured to perform hard-decision decoding on the multiple codewords to obtain a second decoding result of each codeword in the multiple codewords.

The switching control unit 12 may be further specifically configured to:

compare the first decoding result of each codeword in the multiple codewords with the second decoding result of each codeword in turn, and determine that the codeword is accurately decoded if the first decoding result and the second decoding result of the codeword are the same, so as to obtain the quantity of accurately decoded codewords.

A method for determining whether the first decoding result and the second decoding result are the same includes:

> determining that the first decoding result and the second decoding result are the same if a value of each bit in the first decoding result of the codeword is exactly the same as a value of a corresponding bit in the second decoding result; or
> determining that the first decoding result and the second decoding result are the same if a quantity of bits for which a value of each bit in the first decoding result of the codeword is different from a value of a corresponding bit in the second decoding result is less than or equal to a preset quantity.

Optionally, the hard-decision decoding unit 13 may be further configured to:

> (d) perform hard-decision decoding on the decoding result in step (a);
> (e) obtain a quantity of accurately decoded codewords in a decoding result in step (d); and
> (f) determine whether the quantity of accurately decoded codewords is equal to a total quantity of codewords in the decoding result in step (d); and if the quantity of accurately decoded codewords is equal to the total quantity of codewords, determine that a quit condition is met and quit a decoding iteration; or if the quantity of accurately decoded codewords is less than the total quantity of codewords, determine that a quit condition is not met, perform hard-decision decoding on the decoding result in step (d), and perform step (e) and step (f) again.

According to the decoder provided in this embodiment of the present invention, after soft-decision decoding is performed at least once on multiple codewords, whether a decoding result of soft-decision decoding meets a switching condition for switching to hard-decision decoding is determined. If the switching condition is not met, soft-decision decoding continues to be used during next decoding; or if the switching condition is met, hard-decision decoding is switched to during next decoding, and hard-decision decoding is always used during subsequent decoding until a decoding iteration is quit. In this way, when a decoding result of soft-decision decoding meets a specific condition, decoding can switch to hard-decision decoding that requires lower power consumption, and continual use of soft-decision decoding that requires higher power consumption can be avoided, thereby reducing power consumption of a decoder without impairing decoding performance.

The foregoing apparatus embodiment is used to implement the foregoing method embodiments. For a specific workflow and working principle of each unit in this embodiment, refer to the descriptions in the foregoing method embodiments, and details are not described herein again.

An embodiment of the present invention provides a decoder 2, and as shown in FIG. 8, the decoder 1 includes a processor 21, a memory 22, and an input/output interface 23. The processor 21, the memory 22, and the input/output interface 23 are electrically connected by using a bus 24. The input/output interface 23 is configured to interact with another device. The memory 22 is configured to store a computer program 221. The processor 21 is configured to execute the computer program 221, so as to:

> (a) perform N times of soft-decision decoding on multiple codewords, where N is greater than or equal to 1, and perform step (b) after completing the N times of soft-decision decoding;
> (b) determine whether a decoding result in step (a) meets a switching condition for switching to hard-decision decoding; and perform step (c) if the switching condition is met; or return to step (a) if the switching condition is not met; and
> (c) perform hard-decision decoding on the decoding result in step (a) until a decoding iteration is quit.

Optionally, the executing, by the processor 21, the computer program 221 may be specifically used to:

> determine whether a quantity of accurately decoded codewords in the decoding result in step (a) reaches a preset target quantity; and determine that the switching condition is met if the preset target quantity is reached; or determine that the switching condition is not met if the preset target quantity is not reached; or
> obtain decoding accuracy according to a quantity of accurately decoded codewords, where the decoding accuracy is a ratio of a quantity of accurately decoded codewords to a total quantity of decoded codewords in one soft-decision decoding process;
> determine whether the decoding accuracy is less than preset target accuracy; and
> determine that the switching condition is not met if the decoding accuracy is less than the preset target accuracy; or
> determine that the switching condition is met if the decoding accuracy is greater than or equal to the preset target accuracy.

Optionally,
the preset target quantity and the preset target accuracy are preset according to an error correction capability of hard-decision decoding, where
the preset target quantity is equal to a total quantity of codewords in one soft-decision decoding process minus a quantity of erroneous codewords that can be corrected by means of hard-decision decoding; and
the preset target accuracy is equal to the preset target quantity divided by the total quantity of codewords in one soft-decision decoding process.

Optionally, the decoding result in step (a) includes a first decoding result of each codeword in the multiple codewords, and the executing, by the processor 21, the computer program 221 may be specifically used to:

perform hard-decision decoding on the multiple codewords to obtain a second decoding result of each codeword in the multiple codewords; and compare the first decoding result of each codeword in the multiple codewords with the second decoding result of each codeword in turn, and determine that the codeword is accurately decoded if the first decoding result and the second decoding result of the codeword are the same, so as to obtain the quantity of accurately decoded codewords.

A method for determining whether the first decoding result and the second decoding result are the same includes:

determining that the first decoding result and the second decoding result are the same if a value of each bit in the first decoding result of the codeword is exactly the same as a value of a corresponding bit in the second decoding result; or determining that the first decoding result and the second decoding result are the same if a quantity of bits for which a value of each bit in the first decoding result of the codeword is different from a value of a corresponding bit in the second decoding result is less than or equal to a preset quantity.

Optionally, the executing, by the processor 21, the computer program 221 may be specifically used to:

(d) perform hard-decision decoding on the decoding result in step (a);
(e) obtain a quantity of accurately decoded codewords in a decoding result in step (d); and
(f) determine whether the quantity of accurately decoded codewords is equal to a total quantity of codewords in the decoding result in step (d); and if the quantity of accurately decoded codewords is equal to the total quantity of codewords, determine that a quit condition is met and quit a decoding iteration; or if the quantity of accurately decoded codewords is less than the total quantity of codewords, determine that a quit condition is not met, perform hard-decision decoding on the decoding result in step (d), and perform step (e) and step (f) again.

According to the decoder provided in this embodiment of the present invention, after soft-decision decoding is performed at least once on multiple codewords, whether a decoding result of soft-decision decoding meets a switching condition for switching to hard-decision decoding is determined. If the switching condition is not met, soft-decision decoding continues to be used during next decoding; or if the switching condition is met, hard-decision decoding is switched to during next decoding, and hard-decision decoding is always used during subsequent decoding until a decoding iteration is quit. In this way, when a decoding result of soft-decision decoding meets a specific condition, decoding can switch to hard-decision decoding that requires lower power consumption, and continual use of soft-decision decoding that requires higher power consumption can be avoided, thereby reducing power consumption of a decoder without impairing decoding performance.

The foregoing apparatus embodiment is used to implement the foregoing method embodiments. For a specific workflow and working principle of each unit in this embodiment, refer to the descriptions in the foregoing method embodiments, and details are not described herein again.

In the several embodiments provided in the present invention, it should be understood that the disclosed apparatus and method may be implemented in other manners. For example, the described apparatus embodiment is merely exemplary. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit. The integrated unit may be implemented in a form of hardware, or may be implemented in a form of hardware in addition to a software functional unit.

When the foregoing integrated unit is implemented in a form of a software functional unit, the integrated unit may be stored in a computer-readable storage medium. The software functional unit is stored in a storage medium and includes several instructions for instructing a computer device (which may be a personal computer, a server, or a network device) or a processor (processor) to perform a part of the steps of the methods described in the embodiments of the present invention. The foregoing storage medium includes: any medium that can store program code, such as a USB flash drive, a removable hard disk, a read-only memory (Read-Only Memory, ROM), a random access memory (Random Access Memory, RAM), a magnetic disk, or an optical disc.

It may be clearly understood by persons skilled in the art that, for the purpose of convenient and brief description, division of the foregoing function modules is taken as an example for illustration. In actual application, the foregoing functions can be allocated to different function modules and implemented according to a requirement, that is, an inner structure of an apparatus is divided into different function modules to implement all or part of the functions described above. For a detailed working process of the foregoing apparatus, reference may be made to a corresponding process in the foregoing method embodiments, and details are not described herein.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of the present invention.

**Claims**

1. A decoding method, wherein the method comprises the following steps:

   (a) performing N times of soft-decision decoding on multiple codewords, wherein N is greater than or equal to 1, and performing step (b) after completing the N times of soft-decision decoding;
   (b) determining whether a decoding result in step (a) meets a switching condition for switching to hard-decision decoding; and performing step (c) if the switching condition is met; or returning to step (a) if the switching condition is not met; and
   (c) performing hard-decision decoding on the decoding result in step (a) until a decoding iteration is quit.

2. The method according to claim 1, wherein the determining whether a decoding result in step (a) meets a switching condition for switching to hard-decision decoding comprises:

   determining whether a quantity of accurately decoded codewords in the decoding result in step (a) reaches a preset target quantity; and determining that the switching condition is met if the preset target quantity is reached; or determining that the switching condition is not met if the preset target quantity is not reached; or
obtaining decoding accuracy according to the quantity of accurately decoded codewords, wherein the decoding accuracy is a ratio of a quantity of accurately decoded codewords to a total quantity of decoded codewords in one soft-decision decoding process; determining whether the decoding accuracy is less than preset target accuracy; and determining that the switching condition is not met if the decoding accuracy is less than the preset target accuracy; or determining that the switching condition is met if the decoding accuracy is greater than or equal to the preset target accuracy.

3. The method according to claim 2, wherein the preset target quantity and/or the preset target accuracy are/is preset according to an error correction capability of hard-decision decoding, wherein
the preset target quantity is equal to a total quantity of codewords in one soft-decision decoding process minus a quantity of erroneous codewords that can be corrected by means of hard-decision decoding; and
the preset target accuracy is equal to the preset target quantity divided by the total quantity of codewords in one soft-decision decoding process.

4. The method according to claim 2, wherein the decoding result in step (a) comprises a first decoding result of each codeword in the multiple codewords, and a method for obtaining the quantity of accurately decoded codewords in the decoding result in step (a) comprises:

   performing hard-decision decoding on the multiple codewords to obtain a second decoding result of each codeword in the multiple codewords; and
   comparing the first decoding result of each codeword in the multiple codewords with the second decoding result of each codeword in turn, and determining that the codeword is accurately decoded if the first decoding result and the second decoding result of the codeword are the same, so as to obtain the quantity of accurately decoded codewords, wherein
   a method for determining whether the first decoding result and the second decoding result are the same comprises:

   determining that the first decoding result and the second decoding result are the same if a value of each bit in the first decoding result of the codeword is exactly the same as a value of a corresponding bit in the second decoding result; or
determining that the first decoding result and the second decoding result are the same if a quantity of bits for which a value of each bit in the first decoding result of the codeword is different from a value of a corresponding bit in the second decoding result is less than or equal to a preset quantity.

**5.** The method according to any one of claims 1 to 4, wherein step (c) comprises:

(d) performing hard-decision decoding on the decoding result in step (a);
(e) obtaining a quantity of accurately decoded codewords in a decoding result in step (d); and
(f) determining whether the quantity of accurately decoded codewords is equal to a total quantity of codewords in the decoding result in step (d); and if the quantity of accurately decoded codewords is equal to the total quantity of codewords, determining that a quit condition is met and quitting a decoding iteration; or if the quantity of accurately decoded codewords is less than the total quantity of codewords, determining that a quit condition is not met, performing hard-decision decoding on the decoding result in step (d), and performing step (e) and step (f) again.

**6.** A decoder, wherein the decoder comprises:

a soft-decision decoding unit, configured to perform step (a): performing N times of soft-decision decoding on multiple codewords, wherein N is greater than or equal to 1, and performing step (b) after completing the N times of soft-decision decoding;
a switching control unit, configured to perform step (b): determining whether a decoding result in step (a) meets a switching condition for switching to hard-decision decoding; and performing step (c) if the switching condition is met; or returning to step (a) if the switching condition is not met; and
a hard-decision decoding unit, configured to perform step (c): performing hard-decision decoding on the decoding result in step (a) until a decoding iteration is quit.

**7.** The decoder according to claim 6, wherein the switching control unit is specifically configured to:

determine whether a quantity of accurately decoded codewords in the decoding result in step (a) reaches a preset target quantity; and determine that the switching condition is met if the preset target quantity is reached; or determine that the switching condition is not met if the preset target quantity is not reached; or
obtain decoding accuracy according to the quantity of accurately decoded codewords, wherein the decoding accuracy is a ratio of a quantity of accurately decoded codewords to a total quantity of decoded codewords in one soft-decision decoding process; determine whether the decoding accuracy is less than preset target accuracy; and determine that the switching condition is not met if the decoding accuracy is less than the preset target accuracy; or determine that the switching condition is met if the decoding accuracy is greater than or equal to the preset target accuracy.

**8.** The decoder according to claim 7, wherein the preset target quantity and/or the preset target accuracy are/is preset according to an error correction capability of hard-decision decoding, wherein
the preset target quantity is equal to a total quantity of codewords in one soft-decision decoding process minus a quantity of erroneous codewords that can be corrected by means of hard-decision decoding; and
the preset target accuracy is equal to the preset target quantity divided by the total quantity of codewords in one soft-decision decoding process.

**9.** The decoder according to claim 7, wherein: the decoding result in step (a) comprises a first decoding result of each codeword in the multiple codewords, and the hard-decision decoding unit is further configured to perform hard-decision decoding on the multiple codewords to obtain a second decoding result of each codeword in the multiple codewords; and the switching control unit is further specifically configured to:

compare the first decoding result of each codeword in the multiple codewords with the second decoding result of each codeword in turn, and determine that the codeword is accurately decoded if the first decoding result and the second decoding result of the codeword are the same, so as to obtain the quantity of accurately decoded codewords, wherein
a method for determining whether the first decoding result and the second decoding result are the same comprises:

determining that the first decoding result and the second decoding result are the same if a value of each bit in the first decoding result of the codeword is exactly the same as a value of a corresponding bit in the second decoding result; or
determining that the first decoding result and the second decoding result are the same if a quantity of bits for which a value of each bit in the first decoding result of the codeword is different from a value of a corresponding bit in the second decoding result is less than or equal to a preset quantity.

10. The decoder according to any one of claims 6 to 9, wherein the hard-decision decoding unit is further configured to:

(d) perform hard-decision decoding on the decoding result in step (a);
(e) obtain a quantity of accurately decoded codewords in a decoding result in step (d); and
(f) determine whether the quantity of accurately decoded codewords is equal to a total quantity of codewords in the decoding result in step (d); and if the quantity of accurately decoded codewords is equal to the total quantity of codewords, determine that a quit condition is met and quit a decoding iteration; or if the quantity of accurately decoded codewords is less than the total quantity of codewords, determine that a quit condition is not met, perform hard-decision decoding on the decoding result in step (d), and perform step (e) and step (f) again.

11. A decoder, wherein the decoder comprises a processor, a memory, and an input/output interface, wherein the processor, the memory, and the input/output interface are electrically connected by using a bus, the input/output interface is configured to interact with another device, the memory is configured to store a computer program, and the processor performs the following steps when the computer program is being executed by the processor:

(a) performing N times of soft-decision decoding on multiple codewords, wherein N is greater than or equal to 1, and performing step (b) after completing the N times of soft-decision decoding;
(b) determining whether a decoding result in step (a) meets a switching condition for switching to hard-decision decoding; and performing step (c) if the switching condition is met; or returning to step (a) if the switching condition is not met; and
(c) performing hard-decision decoding on the decoding result in step (a) until a decoding iteration is quit.

12. The decoder according to claim 11, wherein the executing, by the processor, the computer program is specifically used to:

determine whether a quantity of accurately decoded codewords in the decoding result in step (a) reaches a preset target quantity; and determine that the switching condition is met if the preset target quantity is reached; or determine that the switching condition is not met if the preset target quantity is not reached; or
obtain decoding accuracy according to the quantity of accurately decoded codewords, wherein the decoding accuracy is a ratio of a quantity of accurately decoded codewords to a total quantity of decoded codewords in one soft-decision decoding process;
determine whether the decoding accuracy is less than preset target accuracy; and
determine that the switching condition is not met if the decoding accuracy is less than the preset target accuracy; or
determine that the switching condition is met if the decoding accuracy is greater than or equal to the preset target accuracy.

13. The decoder according to claim 12, wherein:

the preset target quantity and the preset target accuracy are preset according to an error correction capability of hard-decision decoding, wherein
the preset target quantity is equal to a total quantity of codewords in one soft-decision decoding process minus a quantity of erroneous codewords that can be corrected by means of hard-decision decoding; and
the preset target accuracy is equal to the preset target quantity divided by the total quantity of codewords in one soft-decision decoding process.

14. The decoder according to claim 12, wherein the decoding result in step (a) comprises a first decoding result of each codeword in the multiple codewords, and the executing, by the processor, the computer program is specifically used to:

perform hard-decision decoding on the multiple codewords to obtain a second decoding result of each codeword in the multiple codewords; and
compare the first decoding result of each codeword in the multiple codewords with the second decoding result of each codeword in turn, and determine that the codeword is accurately decoded if the first decoding result and the second decoding result of the codeword are the same, so as to obtain the quantity of accurately decoded codewords, wherein
a method for determining whether the first decoding result and the second decoding result are the same comprises:

determining that the first decoding result and the second decoding result are the same if a value of each bit in the first decoding result of the codeword is exactly the same as a value of a corresponding bit in the second decoding result; or

determining that the first decoding result and the second decoding result are the same if a quantity of bits for which a value of each bit in the first decoding result of the codeword is different from a value of a corresponding bit in the second decoding result is less than or equal to a preset quantity.

**15.** The decoder according to any one of claims 11 to 14, wherein the executing, by the processor, the computer program is specifically used to:

(d) perform hard-decision decoding on the decoding result in step (a);
(e) obtain a quantity of accurately decoded codewords in a decoding result in step (d); and
(f) determine whether the quantity of accurately decoded codewords is equal to a total quantity of codewords in the decoding result in step (d); and if the quantity of accurately decoded codewords is equal to the total quantity of codewords, determine that a quit condition is met and quit a decoding iteration; or if the quantity of accurately decoded codewords is less than the total quantity of codewords, determine that a quit condition is not met, perform hard-decision decoding on the decoding result in step (d), and perform step (e) and step (f) again.

FIG. 1

Obtain soft information of multiple to-be-decoded codewords, where the soft information of the multiple codewords includes soft information of each codeword ———— S201

Generate at least one test sequence for each codeword according to soft information of each bit in the codeword ———— S202

Perform soft decision decoding on each codeword according to all test sequences generated for the codeword, to obtain at least one hard output result of each codeword ———— S203

Select, from all hard output results of each codeword, an optimal hard output result as a first decoding result of the codeword ———— S204

Obtain extrinsic information of each bit in each codeword according to soft information of each bit in the codeword, the first decoding result, and a suboptimal hard output result ———— S205

Determine whether a maximum quantity of times of decoding is reached ———— S206    Yes

No

Determine whether dynamic control information meets a switching condition ———— S207

No

Yes

Perform hard decision decoding on a decoding result in step S204 ———— S208

Determine whether the maximum quantity of times of decoding is reached ———— S209    Yes

No

Determine whether dynamic control information meets a quit condition ———— S210

No

Yes

Quit a decoding iteration, and output a decoding result ———— S211

FIG. 2

FIG. 3

FIG. 4

|      | 1 | 2 | 3 | 4 | 5 | 6 | 7 | 8 | 9 | 10 | ... |
|------|---|---|---|---|---|---|---|---|---|----|-----|
| *D0*  | 1 | 0 | 0 | 1 | 1 | 0 | 1 | 0 | 0 | 1 | ... |
| *BS1* | 0 | 0 | 0 | 0 | 0 | 0 | 0 | 0 | 0 | 0 | ... |
| *TS1* | 1 | 0 | 0 | 1 | 1 | 0 | 1 | 0 | 0 | 1 | ... |
| *BS2* | 0 | 0 | 0 | 0 | 0 | 0 | 1 | 0 | 0 | 0 | ... |
| *TS2* | 1 | 0 | 0 | 1 | 1 | 0 | 0 | 0 | 0 | 1 | ... |
| *BS3* | 0 | 0 | 1 | 0 | 0 | 0 | 0 | 0 | 0 | 0 | ... |
| *TS3* | 1 | 0 | 1 | 1 | 1 | 0 | 1 | 0 | 0 | 1 | ... |
| *BS4* | 0 | 0 | 1 | 0 | 0 | 0 | 1 | 0 | 0 | 0 | ... |
| *TS4* | 1 | 0 | 1 | 1 | 1 | 0 | 0 | 0 | 0 | 1 | ... |

FIG. 5

FIG. 6

Decoder — 1

Soft-decision decoding unit — 11

Switching control unit — 12

Hard-decision decoding unit — 13

FIG. 7

Decoder — 2

Processor — 21

Memory — 22

Computer program — 221

— 24

Input/Output interface — 23

FIG. 8

# INTERNATIONAL SEARCH REPORT

| International application No. |
| --- |
| **PCT/CN2014/083434** |

## A. CLASSIFICATION OF SUBJECT MATTER

H03M 13/05 (2006.01) i

According to International Patent Classification (IPC) or to both national classification and IPC

## B. FIELDS SEARCHED

Minimum documentation searched (classification system followed by classification symbols)

H03M; H04L; G06F

Documentation searched other than minimum documentation to the extent that such documents are included in the fields searched

Electronic data base consulted during the international search (name of data base and, where practicable, search terms used)

WPI; EPODOC; CNKI; CNPAT: soft-decision, hard-decision, switch, error, control, FEC, decod+, soft, hard, decision?, threshold, iterative

## C. DOCUMENTS CONSIDERED TO BE RELEVANT

| Category* | Citation of document, with indication, where appropriate, of the relevant passages | Relevant to claim No. |
| --- | --- | --- |
| A | US 2009158127 A1 (MIYAUCHI, T. et al.), 18 June 2009 (18.06.2009), description, paragraphs 38-70 | 1-15 |
| A | CN 103503319 A (HUAWEI TECHNOLOGIES CO., LTD.), 08 January 2014 (08.01.2014), the whole document | 1-15 |
| A | US 2006045214 A1 (SANYO ELECTRIC CO., LTD.), 02 March 2006 (02.03.2006), the whole document | 1-15 |
| A | WO 2013075126 A1 (SANDISK ENTERPRISE IP LLC), 23 May 2013 (23.05.2013), the whole document | 1-15 |

☐ Further documents are listed in the continuation of Box C.      ☒ See patent family annex.

| *    Special categories of cited documents: | "T"   later document published after the international filing date or priority date and not in conflict with the application but cited to understand the principle or theory underlying the invention |
| --- | --- |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
| --- | --- |
| 13 April 2015 (13.04.2015) | **28 April 2015 (28.04.2015)** |

| Name and mailing address of the ISA/CN: <br> State Intellectual Property Office of the P. R. China <br> No. 6, Xitucheng Road, Jimenqiao <br> Haidian District, Beijing 100088, China <br> Facsimile No.: (86-10) 62019451 | Authorized officer <br><br> **XU, Quan** <br><br> Telephone No.: (86-10) **62413354** |
| --- | --- |

Form PCT/ISA/210 (second sheet) (July 2009)

## INTERNATIONAL SEARCH REPORT
### Information on patent family members

International application No.

**PCT/CN2014/083434**

| Patent Documents referred in the Report | Publication Date | Patent Family | Publication Date |
|---|---|---|---|
| US 2009158127 A1 | 18 June 2009 | JP 2009152654 A | 09 July 2009 |
| CN 103503319 A | 08 January 2014 | WO 2014161171 A1 | 09 October 2014 |
| US 2006045214 A1 | 02 March 2006 | JP 2006074277 A | 16 March 2006 |
| WO 2013075126 A1 | 23 May 2013 | US 2013132804 A1 | 23 May 2013 |
| | | CN 104081358 A | 01 October 2014 |
| | | EP 2780809 A1 | 24 September 2014 |
| | | KR 20140093248 A | 25 July 2014 |
| | | US 2013145231 A1 | 06 June 2013 |
| | | KR 20140093249 A | 25 July 2014 |
| | | CN 104067233 A | 24 September 2014 |
| | | EP 2780810 A2 | 24 September 2014 |
| | | EP 2780808 A2 | 24 September 2014 |
| | | CN 104246706 A | 24 December 2014 |
| | | US 2013145229 A1 | 06 June 2013 |
| | | WO 2013075125 A2 | 23 May 2013 |
| | | WO 2013075128 A2 | 23 May 2013 |

Form PCT/ISA/210 (patent family annex) (July 2009)